# EUROPÄISCHE PATENTSCHRIFT

(11) **EP 1 713 867 B1**
(45) Veröffentlichungstag und Bekanntmachung des Hinweises auf die Patenterteilung: **05.09.2007**
(21) Anmeldenummer: 05771919.7
(22) Anmeldetag: 11.08.2005
(51) Int. Cl.: C09C 1/22

(54) **ELEKTRISCHE LEITFÄHIGE PIGMENTE MIT FERROMAGNETISCHEM KERN, DEREN HERSTELLUNG UND VERWENDUNG**
ELECTRICALLY CONDUCTIVE PIGMENTS HAVING A FERROMAGNETIC CORE, THE PRODUCTION THEREOF AND THEIR USE
PIGMENTS ELECTROCONDUCTEURS A NOYAU FERROMAGNETIQUE, LEUR PRODUCTION ET LEUR UTILISATION

(30) Priorität: 19.08.2004 DE 102004040444
(43) Veröffentlichungstag der Anmeldung: 25.10.2006
(73) Patentinhaber: Eckart GmbH & Co. KG, 90763 Fürth (DE)
(72) Erfinder: SCHUSTER, Thomas, 91207 Lauf (DE); WEISS, Harald, 90765 Fürth (DE)
(74) Vertreter: Walcher, Armin
(86) Internationale Anmeldenummer: PCT/EP2005/008710
(87) Internationale Veröffentlichungsnummer: WO 2006/018213

(56) Entgegenhaltungen:
- EP-A- 0 622 425
- WO-A-03/000801
- DE-A1- 4 104 310
- DE-A1- 4 213 747
- DE-A1- 4 237 990

## Beschreibung

Die Erfindung betrifft elektrisch leitfähige Pigmente, deren Herstellung und Verwendung.

Eisenpigmente finden allgemein Verwendung im dekorativen Bereich sowie als funktionelle Pigmente. Als Anwendungen mit vorwiegend optischen Effekten seien beispielhaft Anstrichmittel und Lackbeschichtungen, Kunststoffeinfärbungen, Druckfarben sowie Färbemittel für Glas und Keramik genannt.

Plättchenförmige Eisenpigmente werden üblicherweise durch Stampfen oder Vermahlen von verdüstem Eisengrieß unter Zusatz von Schmiermitteln hergestellt. In der EP 673 980 werden solche Verfahren ausführlich beschrieben. Auf diese Weise werden insbesondere relativ grobe Teilchen mit einer breiten Teilchengrößenverteilung erhalten.

Ein anderes Verfahren zur Herstellung von plättchenförmigen Eisenpigmenten ist die Dampfabscheidung im Vakuum unter Verwendung von PVD-Verfahren, vorzugsweise durch Elektronenstrahl, bei der eine dünne Eisenschicht auf einem Trägermaterial abgeschieden wird, welche anschließend zu Pigmenten zerkleinert werden kann. So werden Teilchen mit gleichmäßiger Dicke und hohem Reflexionsvermögen erhalten.

WO03/000801 offenbart ein Pigment bestehend aus einem ferromagnetischen Kern und einer metallischen, reflektierenden Schicht, wobei das besagte Pigment mittels eines CVD-Verfahrens hergestellt wird. Unter anderem wird ein Pigment bestehend aus einem Eisenkern und einer aus Aluminium bestehenden reflektierenden Schicht offenbart.

Die Herstellung von Eisenpigmenten aus reduzierend behandeltem Carbonyleisenpulver wird in der DE 101 14 446 A1 beschrieben. Bei der Vermahlung, die nass oder trocken durchgeführt werden kann, erfolgt im wesentlichen nur eine Verformung des Ausgangsmaterials zu Plättchen und keine Zerkleinerung. Um ein Kaltverschweißen der Eisenteilchen bei der Vermahlung zu verhindern, muss ein Schmiermittel, beispielsweise eine Fettsäure wie Stearin- oder Ölsäure, zugesetzt werden. Ziel der in der DE 101 14 446 A1 beschriebenen Erfindung ist die Bereitstellung von Eisenpigmenten, die in optisch anspruchsvollen Beschichtungen verwendet werden können.

Aufgabe der vorliegenden Erfindung ist es, elektrisch leitfähige Pigmente zu finden, die neue Anwendungsmöglichkeiten erlauben. Eine weitere Aufgabe der Erfindung ist es, Pigmente bereitzustellen, die nach Aufbringung auf einen Gegenstand oder Einbringung in einen Gegenstand über nachweisbare magnetische und/oder elektrische Eigenschaften verfügen.

Die Erfinder haben nunmehr überraschend gefunden, daß sich weitere Anwendungsmöglichkeiten durch die Bereitstellung von elektrisch leitfähigen Pigmenten gemäß Anspruch 1 ergeben, die einen ferromagnetischen Kern und wenigstens eine elektrisch leitfähige Beschichtung aufweisen.

Bevorzugte Weiterbildungen der elektrisch leitfähigen Pigmente sind in den Unteransprüchen 2 bis 7 angegeben.

Gemäß einer bevorzugten Weiterbildung der Erfindung liegt der ferromagnetische Kern der erfindungsgemäßen Pigmente in plättchenartiger Form vor. Die plättchenförmigen erfindungsgemäßen Pigmente weisen vorzugsweise Größen von 2 bis 500 µm, bevorzugt von 5 bis 200 µm und besonders bevorzugt von 10 bis 50 µm auf.

Nach Aufbringung der elektrisch leitfähigen Beschichtung auf einen plättchenartigen ferromagnetischen Kern werden üblicherweise plättchenartige Pigmente erhalten.

Besonders bevorzugt wird der ferromagnetische Kern aus Eisen aus Carbonyleisengrieß durch Nassvermahlung hergestellt und weist vorzugsweise eine Dicke unter 150 nm auf. Beispielsweise wird ein derartiges Pigment gemäß der DE 101 14 446 A1 hergestellt, welche hiermit unter Bezugnahme aufgenommen wird.

Das elektrisch leitfähige Material umfasst oder ist ein Metall oder eine Metalllegierung. Vorzugsweise wird das Metall bzw. die Metalllegierung aus der Gruppe, die aus Rhodium, Nickel, Silber, deren Gemischen und Legierungen, die diese Metalle enthalten, besteht, ausgewählt.

Als elektrisch leitfähiges Material können aber auch elektrisch leitfähige Polymere, oder Kunststoffe, die die vorgenannten elektrisch leitfähigen Polymere enthalten, verwendet werden.

Vorzugsweise werden die elektrisch leitfähigen Polymere aus der Gruppe ausgewählt, die aus Polypyrrol, Polythiophen, Polyphenylen, Polyanilin, Polyacetylen und Mischungen davon besteht.

Die Dicke der elektrisch leitenden Beschichtung beträgt vorzugsweise 5 bis 200 nm, besonders bevorzugt 10 bis 100 nm.

Die erfindungsgemäßen leitfähig beschichteten Pigmente, vorzugsweise Eisenpigmente aus Carbonyleisen, weisen vorzugsweise eine Gesamtdicke von 80 bis 550 nm, bevorzugt von 100 bis 350 nm und besonders bevorzugt von 120 bis 250 nm auf. Es handelt sich vorteilhafterweise um besonders dünne Pigmente, die sich besonders gut im elektrischen oder magnetischen Feld orientieren.

Gemäß der Erfindung werden mithin Pigmente bereitgestellt, die sowohl elektrisch leitfähig sind als auch über ferromagnetische Eigenschaften verfügen.

Elektrisch leitfähige Pigmente, vorzugsweise Eisenpigmente, können - insbesondere unter Berücksichtigung der ferromagnetischen Eigenschaften - zur Herstellung von Sicherheitselementen verwendet werden. Die elektrisch leitfähigen Pigmente gemäß der vorliegenden Erfindung weisen mithin bestimmte elektrische und/oder magnetische Eigenschaften auf, die nachweisbar sind.

Die vorgenannten Sicherheitselemente sind dabei regelmäßig als Flächenelemente ausgebildet, die auf zu sichernde Dokumente oder Gegenstände flächig aufgebracht werden. Die erfindungsgemäßen Pigmente können selbstverständlich auch Teil eines zu sichernden Gegenstandes sein, d.h. beispielsweise in einen Kunststoff eingearbeitet sein. In diesen Fällen ist nur eine einmalige Ausrichtung der erfindungsgemäßen Pigmente durch Anlegen eines elektrischen oder magnetischen Feldes vor der Aushärtung des umgebenden Mediums möglich. Der Gegenstand weist dann aufgrund der Orientierung der erfindungsgemäßen elektrisch leitfähigen Pigmente definierte bzw. nachweisbare magnetische und/oder elektrische Eigenschaften auf.

Die Sicherheitselemente werden vorzugsweise in sogenannten intelligenten Schaltern verwendet. Intelligente Schalter zeichnen sich beispielsweise dadurch aus, dass durch Anlegen eines Magnetfeldes und/oder eines elektrischen Feldes die ferromagnetischen Eisenpigmente in einer Beschichtung oder in einem Gegenstand in eine gewünschte Richtung ausgerichtet werden können. Durch das Anlegen eines elektrischen und/oder magnetischen Feldes können dadurch die elektrische Leitfähigkeit und/oder die optischen Eigenschaften der Beschichtung bzw. des Gegenstandes weitgehend reversibel, vorzugsweise reversibel, verändert werden. In diesem Fall ist das Applikationsmedium ein viskoses Medium, welches einerseits den Pigmenten genügend Beweglichkeit für eine Umorientierung erlaubt, andererseits aber genügend Rückstellkraft für ein Zurückkehren der Pigmente in ihre Ausgangslage besitzt.

Das heißt, durch Anlegen eines vorgegebenen elektrischen und/oder magnetischen Feldes an eine Beschichtung, die die erfindungsgemäßen elektrisch leitfähigen Eisenpigmente enthält, können mithin bestimmte elektrische und/oder optische Effekte einstellbar sein. Wenn dann bei Anlegung des vorgegebenen elektrischen und/oder magnetischen Feldes die erwarteten elektrischen und/oder optischen Effekte nicht erhalten werden, ist dies ein Hinweis darauf, daß der gesicherte Gegenstand eine Fälschung ist.

Im Sinne der Erfindung werden die Sicherheitselemente, wie beispielsweise Hologramme, vorzugsweise zur Identifizierung der Echtheit von Sicherheitsdokumenten wie Banknoten, Ausweisen, Ausweiskarten, Scheckkarten, Kreditkarten, Wertschriften, Sicherheitsgegenständen wie Medikamenten, Datenträgern, etc. verwendet.

Die elektrisch leitfähigen Pigmente gemäß der vorliegenden Erfindung, vorzugsweise mit einem Eisenpigmentkern, können auch als Beschichtung oder Zwischenschicht von transparenten Trägermaterialien, beispielsweise von Glas- oder Kunststoffscheiben, verwendet werden. In Abhängigkeit von dem angelegten elektrischen Feld kann die Durchsichtigkeit bzw. die optische Transparenz des an sich transparenten Trägermaterials eingestellt bzw. verändert werden. Beispielsweise können die Glas- oder Kunststoffscheiben für sichtbares Licht, UV-Strahlung und/oder IR-Strahlung undurchlässig gemacht werden.

Es ist mithin möglich, die erfindungsgemäßen elektrisch leitfähigen Pigmente, vorzugsweise mit einem Eisenpigmentkern, als Schutzschicht auf Glas- oder Kunststoffscheiben aufzubringen, um einstrahlendes Sonnenlicht - nach Anlegung eines elektrischen Feldes - zu reflektieren und somit eine Aufwärmung eines Gebäudes zu verhindern. Die Beschichtung kann - nach Anlegung eines elektrischen Feldes - auch dazu dienen, die Durchsichtigkeit für sichtbares Licht zu verringern, so daß beispielsweise ein verglaster Raum für Dritte nicht mehr einsehbar ist.

Die erfindungsgemäßen elektrisch leitfähigen Pigmente können auch zur elektromagnetischen Abschirmung verwendet werden. Beispielsweise kann ein Gehäuse einer elektrischen oder elektronischen Vorrichtung mit einer Beschichtung versehen werden, die die erfindungsgemäßen elektrisch leitfähigen Pigmente enthält. Die elektrisch leitfähigen Pigmente können auch in Kunststoffe eingearbeitet werden, aus denen dann beispielsweise Kunststoffgehäuse gefertigt werden können, die die elektromagnetische Strahlung zuverlässig abschirmen.

Aufgrund der elektromagnetischen Eigenschaften der erfindungsgemäßen elektrisch leitfähigen Pigmente ist mithin eine zuverlässige Abschirmung von elektromagnetischer Strahlung möglich.

Die erfindungsgemäßen leitfähigen Pigmente finden mithin Verwendung in leitfähigen Beschichtungen, leitfähigen Gegenständen, Beschichtungen oder Gegenständen mit elektromagnetische Strahlung abschirmenden Eigenschaften sowie in Schaltern oder als intelligente Schalter.

Die der Erfindung zugrundeliegende Aufgabe wird auch durch Bereitstellung einer Pigmentmischung gelöst, die eine Mischung von plättchenartigen, elektrisch leitfähigen Pigmenten gemäß der vorliegenden Erfindung gelöst.

Es hat sich überraschenderweise gezeigt, daß bei Aufbringung der erfindungsgemäßen Pigmentmischung, beispielsweise in Form einer Beschichtung, auf einen Gegenstand oder bei Einbringung in einen Gegenstand die elektrische Leitfähigkeit verbessert werden kann. Die verbesserte Leitfähigkeit wird dabei auf die erhöhte Kontaktwahrscheinlichkeit bzw. die erhöhte Anzahl an Kontakten der plättchenartigen Pigmenten in der Pigmentmischung zurückgeführt.

Die der Erfindung zugrundeliegende Aufgabe wird des weiteren durch ein Verfahren zur Herstellung elektrisch leitfähiger Pigmente gemäß Anspruch 8, wobei auf einem ferromagnetischen Ausgangspigment wenigstens eine Beschichtung aus wenigstens einem elektrisch leitfähigen Material aufgebracht wird.

Bevorzugte Weiterbildungen des erfindungsgemäßen Verfahrens sind in den Unteransprüchen 9 bis 17 angegeben.

Für Anwendungen im Bereich der elektromagnetischen Abschirmung oder sogenannter "intelligenter Schalter" sind die durch Mahlverfahren erhaltenen Pigmente, vorzugsweise Eisenpigmente, in der Regel als solche nicht verwendbar, da die Schmiermittelschicht auf den Pigmenten, vorzugsweise Eisenpigmenten, außergewöhnlich stark haftet.

Wenn das Ausgangspigment eine Schicht aus Schmiermittel aufweist, so muss es vor der Beschichtung mit dem leitfähigen Material entfettet werden.

Insbesondere ist bei den bevorzugt verwendeten Eisenpigmenten, die herkömmlicherweise durch Vermahlung, beispielsweise in einer Kugelmühle, unter Zusatz von Schmiermitteln hergestellt werden, die Eisenpigmentoberfläche nachteiligerweise mit einer festanhaftenden Schmiermittelschicht belegt. Die Schmiermittelschicht besteht üblicherweise aus Stearin- oder Ölsäure sowie deren Eisensalzen und Abbauprodukten. Darüber hinaus weisen die Eisenpigmente in der Regel noch eine Oxidschicht an der Eisenpigmentoberfläche auf. Die Schmiermittelschicht und die Oxidschicht bewirken, daß kein elektrisch leitender Kontakt zwischen benachbarten Eisenpigmentteilchen besteht.

Um die durch Vermahlung hergestellten Pigmente, insbesondere die Eisenpigmente, elektrisch leitfähig zu machen, werden die Pigmente, bevorzugt Eisenpigmente, gemäß der vorliegenden Erfindung mit einer elektrisch leitfähigen Beschichtung versehen.

Es hat sich jedoch gezeigt, dass es nicht bzw. nur schlecht möglich ist, mit herkömmlichen Methoden nennenswerte Mengen des Schmiermittels von den Pigmenten, insbesondere den Eisenpigmenten, zu entfernen. Ein bekanntes Verfahren, bei dem Aluminiumpigmente in einem sauerstoffhaltigen Gas bewegt und gewünschtenfalls zusätzlich mit Wasserdampf behandelt werden, um die Schmiermittelschicht weitgehend zu entfernen, ist beispielsweise in der EP 580 022 B1 beschrieben. Das aus der EP 580 022 bekannte Verfahren ist für die Entfettung von Eisenpigmenten ebenfalls geeignet.

Bevorzugt jedoch erfolgt die Entfettung der Ausgangspigmente, vorzugsweise von Eisenpigmenten, durch Behandlung derselben mit konzentrierter NaOH in einem organischen Lösemittel. Vorzugsweise wird als Entfettungslösung eine konzentrierte alkoholische NaOH- Lösung wie beispielsweise ca. 10 Gew.-%ige NaOH in Ethanol verwendet.

Die Erfinder haben nun überraschenderweise herausgefunden, daß elektrisch leitfähige Pigmente mit ferromagnetischen Eigenschaften hergestellt werden können, wenn ferromagnetische Pigmente, vorzugsweise entfettete Pigmente, weiter bevorzugt entfettete Eisenpigmente, mit einer elektrisch leitfähigen Beschichtung versehen werden.

Vorzugsweise werden Eisenpigmente aus Carbonyleisen eingesetzt, da diese wegen ihrer im Vergleich zu herkömmlichen Eisenpigmenten geringeren Dicke ein besseres Orientierungsverhalten in einer Beschichtung oder in einem bzw. auf einem Gegenstand zeigen.

Bei Verwendung von Eisenpigmenten als Ausgangspigmente werden diese vorzugsweise durch Vermahlen von Eisenpulver, bevorzugt von Carbonyl-Eisenpulver, erhalten.

Eisenpigmente eignen sich hervorragend als Ausgangspigment bei der Herstellung der erfindungsgemäßen elektrisch leitfähigen Pigmente, da Eisenpigmente relativ preiswert herstellbar sind und gute anwendungstechnische Eigenschaften zeigen.

Wesentliches Merkmal der erfindungsgemäßen Pigmente ist, dass die ferromagnetischen Eigenschaften des Kerns trotz der Beschichtung mit einem elektrisch leitfähigen Material erhalten bleiben.

Das leitfähige Material kann beispielsweise in einem Wirbelbettverfahren aus einer geeigneten Vorstufe, beispielsweise einem Metallcarbonyl, auf das Ausgangspigment aufgebracht werden.

Das leitfähige metallische Material M kann auch in einem nasschemischen Verfahren durch stromlose Abscheidung gemäß der Formel (1)

Fe + M^{z+} + Red → Fe/M + Ox (I)

und/oder-wenn M edler ist als Eisen -gemäß der Formel (II)

Fe + M^{z+} → Fe/M + Fe^{2/3+} (II)

auf das bevorzugt zu verwendende Eisen-Ausgangspigment aufgebracht werden, wobei "Red" für Reduktionsmittel steht, das in eine oxidierte Form "Ox" überführt wird.

Als Reduktionsmittel kann/können beispielsweise einer oder mehrere Substanzen aus der Gruppe Hydrazin, Aldehyde, Methanol, Ethanol, Zucker, Hypophosphit und/oder Formaldehyd eingesetzt werden.

Bei einer möglichen Ausführungsform kann zunächst das edlere Metall ohne Gegenwart eines Reduktionsmittels abgeschieden werden und nachfolgend eine Reduktion in Gegenwart eines Reduktionsmittels durchgeführt werden. Dies kann nötig sein, da bei der stromlosen Abscheidung nach Formel (II) die Reaktion zum Stillstand kommen kann, sobald die Beschichtung eine solche Dicke und Dichtigkeit erreicht hat, von der an das Eisen als Reaktionspartner nicht mehr zur Verfügung steht. Um die gewünschten Schichtdicken dennoch zu erhalten, ist eine weitere Abscheidung durch Reduktion einer Metallverbindung mit Hilfe eines Reduktionsmittels nach Formel (I) möglich.

Vorzugsweise werden der stromlosen nasschemischen Abscheidung der Metalle zusätzlich Additive, die als Glanzbildner wirken, zugesetzt. Hier kann beispielsweise Milchsäure verwendet werden.

Die der Erfindung zugrundeliegende Aufgabe wird des weiteren durch die Verwendung der erfindungsgemäßen elektrisch leitfähigen Pigmenten bzw. der erfindungsgemäßen Pigmentmischung in elektrisch leitfähigen Beschichtungen und/oder elektrisch leitfähigen Gegenständen gelöst.

Vorzugsweise werden die erfindungsgemäßen elektrisch leitfähigen Pigmente bzw. die erfindungsgemäße Pigmentmischung in Beschichtungen oder Gegenständen zur Abschirmung von elektromagnetischer Strahlung verwendet.

Ferner betrifft die vorliegende Erfindung die Verwendung der erfindungsgemäßen elektrisch leitfähigen Pigmenten bzw. der erfindungsgemäßen Pigmentmischung in intelligenten Schaltern oder Beschichtungen, bei denen durch Anlegen eines Magnetfeldes und/oder eines elektrischen Feldes die elektrisch leitfähigen Pigmente in eine gewünschte Richtung orientiert werden können.

Die Aufgabe der Erfindung wird ferner durch einen Gegenstand, der die erfindungsgemäßen elektrisch leitfähige Pigmente bzw. die erfindungsgemäße Pigmentmischung enthält und/oder aufweist gelöst. Der Gegenstand ist vorzugsweise ein Sicherheitselement, Sicherheitsdokument, Sicherheitsgegenstand oder transparentes Material.

Die nachstehend angeführten Beispiele sollen die Erfindung erläutern, ohne sie zu beschränken.

### Beispiel

100 g Eisenpigment (VP 58031/G) werden in 500 g 10 Gew.-%-iger ethanolischer NaOH-Lsg. für eine Stunde bei 50°C gerührt. Anschließend wird das Produkt abgenutscht, mehrmals mit Ethanol gewaschen und mit Heißluft getrocknet.

100g derartig entfettetes Eisenpigment werden in 300 g entionisiertem Wasser suspendiert. Anschließend gibt man eine Lösung von 200g NiSO₄x 7H₂O, 30 g Milchsäure und 5g Hydrazinsulfat in 2l entionisiertem Wasser hinzu und erhitzt auf 60°C. Anschließend wird eine Lösung von 150g Natriumhyposphosphit in 500 ml entionisiertem Wasser hinzugefügt. Durch geregelte Zugabe einer 1 M NaOH-Lsg. wird danach der pH bei 5,4 konstant eingestellt. Nach zwei Stunden Rühren wird der Reaktionsansatz abgenutscht und der Filterkuchen mit Ethanol mehrmals gewaschen. Anschließend trocknet man über Nacht im Vakuumtrockenschrank.

2,5 g Pigment wurden in 2,5 Essigsäureethylester/Ethanol 1:1 (Gew./Gew.) gut vordispergiert und mit 2,5g einer Neocryllösung B 725 40%-ig in Butylacetat/Isopropanol 1:1 (Vol./Vol.) vermischt und mehrmals umgerührt. Die Applikation erfolgt auf einer Hostaphanfolie mittels einer 100 µm-Kastenrakel. Nach 5 min Ablüftzeit wird die Folie 30 min lang bei 60°C getrocknet. Die Messung des Widerstands erfolgt mittels Zwei-Punktmessung an drei verschiedenen Orten der Probe. Der Mittelwert betrug 1,1 x 10⁻³Ω.

## Patentansprüche

1. Elektrisch leitfähige Pigmente,
**dadurch gekennzeichnet,**
**daß** die Pigmente einen ferromagnetischen Kern und wenigstens eine elektrisch leitfähige Beschichtung aufweisen, wobei die elektrisch leitfähige Beschichtung ein Metall oder eine Metallegierung ist oder umfasst oder wobei die elektrisch leitfähige Beschichtung elektrisch leitfähige Polymere oder Kunststoffe, die elektrisch leitfähige Polymere enthalten, sind oder umfasst, wobei der ferromagnetische Kern aus Eisen aus Carbonyleisengrieß durch Nassvermahlung hergestellt wird und vorzugsweise eine Dicke unter 150 nm aufweist.

2. Elektrisch leitfähige Pigmente nach Anspruch 1,
**dadurch gekennzeichnet,**
**dass** der ferromagnetische Kern plättchenartig ist.

3. Elektrisch leitfähige Pigmente nach einem der Ansprüche 1 bis 2,
**dadurch gekennzeichnet,**
**dass** das Metall aus der Gruppe, die aus Rhodium, Nickel, Silber, deren Gemischen und Legierungen, die diese Metalle enthalten, besteht, ausgewählt ist.

4. Elektrisch leitfähige Pigmente nach einem der Ansprüche 1 bis 2,
**dadurch gekennzeichnet,**
**dass** die elektrisch leitfähigen Polymere aus der Gruppe ausgewählt werden, die aus Polypyrrol, Polythiophen, Polyphenylen, Polyanilin, Polyacetylen und Mischungen davon besteht.

5. Elektrisch leitfähige Pigmente nach einem der vorhergehenden Ansprüche,
**dadurch gekennzeichnet,**
**dass** die Dicke der Beschichtung 5 bis 200 nm, vorzugsweise 10 bis 100 nm, beträgt.

6. Elektrisch leitfähige Pigmente nach einem der vorhergehenden Ansprüche,
**dadurch gekennzeichnet,**
**dass** die Größe der Pigmente 2 bis 500 µm, vorzugsweise 5 bis 200 µm, beträgt.

7. Elektrisch leitfähige Pigmente nach einem der vorhergehenden Ansprüche,
**dadurch gekennzeichnet,**
**dass** die Gesamtdicke der beschichteten Pigmente 80 bis 550 nm, vorzugsweise 100 nm bis 350 nm, beträgt.

8. Verfahren zur Herstellung elektrisch leitfähiger Pigmente, nach einem der Ansprüch 1-7,
**dadurch gekennzeichnet,**
**dass** auf einem ferromagnetischen Ausgangspigment wenigstens eine Beschichtung aus wenigstens einem elektrisch leitfähigen Material aufgebracht wird, wobei das elektrisch leitfähige Material ein Metall oder eine Metallegierung ist oder umfaßt oder wobei das elektrisch leitfähige Material elektrisch leitfähige Polymere oder Kunststoffe, die elektrisch leitfähige Polymere enthalten, sind oder umfaßt, wobei
die Eisenpigmente durch Vermahlen von Carbonyl-Eisenpulver erhalten werden.

9. Verfahren nach Anspruch 8,
**dadurch gekennzeichnet,**
**dass** die Eisenpigmente vor Aufbringung der elektrisch leitfähigen Beschichtung entfettet werden.

10. Verfahren nach Anspruch 9,
**dadurch gekennzeichnet,**
**dass** die Entfettung durch Behandlung der Eisenpigmente mit Natriumhydroxid in einem organischen Lösemittel, bevorzugt Ethanol, erfolgt.

11. Verfahren nach einem der Ansprüche 8 bis 10,
**dadurch gekennzeichnet,**
**dass** das elektrisch leitfähige Material nasschemisch durch stromlose Abscheidung mit oder ohne Reduktionsmittel aufgebracht wird.

12. Verfahren nach einem der Ansprüche 8 bis 11*,*
**dadurch gekennzeichnet,**
**dass** das leitfähige Material aus der Gasphase in einem Wirbelbettverfahren auf die Eisenpigmente aufgebracht wird.

13. Verfahren nach einem der Ansprüche 8 bis 12,
**dadurch gekennzeichnet,**
**dass** das leitfähige Material zunächst durch stromlose Abscheidung ohne Gegenwart von Reduktionsmittel und nachfolgend durch Reduktion mit einem Reduktionsmittel aufgebracht wird.

14. Verfahren nach Anspruch 11 oder 13.
**dadurch gekennzeichnet,**
**dass** das Reduktionsmittel aus der Gruppe, die aus Hydrazin, Aldehyde, Methanol, Ethanol, Zucker, Hypophosphit, Formaldehyd und Mischungen davon besteht; ausgewählt wird.

15. Verfahren nach einem der Ansprüche 8 bis 14,
**dadurch gekennzeichnet,**
**dass** das Metall oder die Metallegierung aus der Gruppe, die aus Rhodium, Nickel, Silber, deren Gemischen und Legierungen davon besteht, ausgewählt wird.

16. Verfahren nach einem der Ansprüche 8 bis 14,
**dadurch gekennzeichnet,**
**dass** die elektrisch leitfähigen Polymere aus der Gruppe ausgewählt werden, die aus Polypyrrol, Polythiophen, Polyphenylen, Polyanilin, Polyacetylen und Mischungen davon besteht.

17. Verfahren nach einem der Ansprüche 8 bis 16,
**dadurch gekennzeichnet,**
**daß** die elektrisch leitfähigen Pigmente plättchenartig sind.

18. Pigmentmischung,
**dadurch gekennzeichnet,**
**dass** die Pigmentmischung eine Mischung von plättchenartigen elektrisch leitfähigen Pigmenten nach einem der Ansprüche 1 bis 7 umfaßt.

19. Verwendung von elektrisch leitfähigen Pigmenten nach einem der Ansprüche 1 bis 7 oder einer Pigmentmischung nach Anspruch 18 in elektrisch leitfähigen Beschichtungen und/oder elektrisch leitfähigen Gegenständen.

20. Verwendung von elektrisch leitfähigen Pigmenten nach einem der Ansprüche 1 bis 7 oder einer Pigmentmischung nach Anspruch 18 in Beschichtungen oder Gegenständen zur Abschirmung von elektromagnetischer Strahlung.

21. Verwendung von elektrisch leitfähigen Pigmenten nach einem der Ansprüche 1 bis 7 oder einer Pigmentmischung nach Anspruch 18 in intelligenten Schaltern oder Beschichtungen, bei denen durch Anlegen eines Magnetfeldes und/oder eines elektrischen Feldes die elektrisch leitfähigen Pigmente in eine gewünschte Richtung orientiert werden können.

22. Gegenstand,
**dadurch gekennzeichnet,**
**dass** der Gegenstand elektrisch leitfähige Pigmente nach einem der Ansprüche 1 bis 7 oder ein Pigmentmischung nach Anspruch 18 enthält und/oder aufweist.

23. Gegenstand nach Anspruch 22,
**dadurch gekennzeichnet,**
**dass** der Gegenstand ein Sicherheitselement, Sicherheitsdokument, Sicherheitsgegenstand oder transparentes Material ist.

## Claims

1. Electrically conductive pigments **characterized in that** the pigments have a ferromagnetic core and at least one electrically conductive coating, the electrically conductive coating being or comprising a metal or metal alloy or the electrically conductive coating being or comprising electrically conductive polymers or plastics which contain electrically conductive polymers, the ferromagnetic core being produced from iron, from carbonyl iron powder by wet milling and preferably having a thickness of less than 150 nm.

2. Electrically conductive pigments according to Claim 1, **characterized in that** the ferromagnetic core is lamellar.

3. Electrically conductive pigments according to either of Claims 1 and 2, **characterized in that** the metal is selected from the group which consists of rhodium, nickel, silver and mixtures and alloys thereof which contain these metals.

4. Electrically conductive pigments according to either of Claims 1 and 2, **characterized in that** the electrically conductive polymers are selected from the group which consists of polypyrrole, polythiophene, polyphenylene, polyaniline, polyacetylene and mixtures thereof.

5. Electrically conductive pigments according to any of the preceding claims, **characterized in that** the thickness of the coating is 5 to 200 nm, preferably 10 to 100 nm.

6. Electrically conductive pigments according to any of the preceding claims, **characterized in that** the size of the pigments is 2 to 500 µm, preferably 5 to 200 µm.

7. Electrically conductive pigments according to any of the preceding claims, **characterized in that** the total thickness of the coated pigments is 80 to 550 nm, preferably 100 nm to 350 nm.

8. Process for the production of electrically conductive pigments according to any of Claims 1-7, **characterized in that** at least one coating comprising at least one electrically conductive material is applied to a ferromagnetic starting pigment, the electrically conductive material being or comprising a metal or a metal alloy or the electrically conductive material being or comprising electrically conductive polymers or plastics which contain electrically conductive polymers, the iron pigments being obtained by milling of carbonyl iron powder.

9. Process according to Claim 8, **characterized in that** the iron pigments are degreased before application of the electrically conductive coating.

10. Process according to Claim 9, **characterized in that** the degreasing is effected by treatment of the iron pigments with sodium hydroxide in an organic solvent, preferably ethanol.

11. Process according to any of Claims 8 to 10, **characterized in that** the electrically conductive material is applied by a wet chemical method by currentless deposition with or without reducing agents.

12. Process according to any of Claims 8 to 11, **characterized in that** the conductive material is applied to the iron pigments from the gas phase in a fluidized-bed process.

13. Process according to any of Claims 8 to 12, **characterized in that** the conductive material is applied first by currentless deposition without the presence of reducing agents and subsequently by reduction with a reducing agent.

14. Process according to Claim 11 or 13, **characterized in that** the reducing agent is selected from the group which consists of hydrazine, aldehydes, methanol, ethanol, sugar, hypophosphite, formaldehyde and mixtures thereof.

15. Process according to any of Claims 8 to 14, **characterized in that** the metal or the metal alloy is selected from the group which consists of rhodium, nickel, silver and mixtures and alloys thereof.

16. Process according to any of Claims 8 to 14, **characterized in that** the electrically conductive polymers are selected from the group which consists of polypyrrole, polythiophene, polyphenylene, polyaniline, polyacetylene and mixtures thereof.

17. Process according to any of Claims 8 to 16, **characterized in that** the electrically conductive pigments are lamellar.

18. Pigment mixture, **characterized in that** the pigment mixture comprises a mixture of lamellar electrically conductive pigments according to any of Claims 1 to 7.

19. Use of electrically conductive pigments according to any of Claims 1 to 7 or of a pigment mixture according to Claim 18 in electrically conductive coatings and/or electrically conductive articles.

20. Use of electrically conductive pigments according to any of Claims 1 to 7 or of a pigment mixture according to Claim 18 in coatings or articles for shielding from electromagnetic radiation.

21. Use of electrically conductive pigments according to any of Claims 1 to 7 or of a pigment mixture according to Claim 18 in intelligent switches or coatings in which the electrically conductive pigments can be oriented in a desired direction by application of a magnetic field and/or of an electric field.

22. Article, **characterized in that** the article contains and/or has electrically conductive pigments according to any of Claims 1 to 7 or a pigment mixture according to Claim 18.

23. Article according to Claim 22, **characterized in that** the article is a security element, security document, security article or transparent material.

## Revendications

1. Pigments électriquement conducteurs,
**caractérisés en ce**
**que** les pigments présentent un noyau ferromagnétique et au moins un revêtement électriquement conducteur, le revêtement électriquement conducteur étant ou comprenant un métal ou un alliage métallique ou bien le revêtement électriquement conducteur étant ou comprenant des polymères électriquement conducteurs ou des plastiques contenant des polymères électriquement conducteurs, dans lesquels le noyau ferromagnétique en fer est produit par broyage humide à partir de grains de fer carbonyle et présente de préférence une épaisseur inférieure à 150 nm.

2. Pigments électriquement conducteurs selon la revendication 1,
**caractérisés en ce**
**que** le noyau ferromagnétique est de type lamellaire.

3. Pigments électriquement conducteurs selon l'une quelconque des revendications 1 et 2,
**caractérisés en ce**
**que** le métal est choisi dans le groupe constitué par le rhodium, le nickel, l'argent, leurs mélanges, ainsi que des alliages contenant ces métaux.

4. Pigments électriquement conducteurs selon l'une quelconque des revendications 1 et 2,
**caractérisés en ce**
**que** les polymères électriquement conducteurs sont choisis dans le groupe constitué par le polypyrrole, le polythiophène, le polyphénylène, la polyaniline, le polyacétylène et des mélanges des ceux-ci.

5. Pigments électriquement conducteurs selon l'une quelconque des revendications précédentes,
**caractérisés en ce**
**que** l'épaisseur du revêtement se situe dans la plage de 5 à 200 nm, de préférence de 10 à 100 nm.

6. Pigments électriquement conducteurs selon l'une quelconque des revendications précédentes,
**caractérisés en ce**
**que** la taille des pigments se situe dans la plage de 2 à 500 µm, de préférence de 5 à 200 µm.

7. Pigments électriquement conducteurs selon l'une quelconque des revendications précédentes,
**caractérisés en ce**
**que** l'épaisseur totale des pigments revêtus se situe dans la plage de 80 à 550 nm, de préférence de 100 nm à 350 nm.

8. Procédé de production de pigments électriquement conducteurs selon l'une quelconque des revendications 1 à 7,
**caractérisé en ce**
**qu'**au moins un revêtement comprenant au moins un matériau électriquement conducteur est déposé sur un pigment de départ ferromagnétique, le matériau électriquement conducteur étant ou comprenant un métal ou un alliage métallique ou bien le matériau électriquement conducteur étant ou comprenant des polymères électriquement conducteurs ou bien des plastiques contenant des polymères électriquement conducteurs, procédé dans lequel les pigments de fer sont obtenus par broyage de poudre de fer carbonyle.

9. Procédé selon la revendication 8,
**caractérisé en ce**
**que** les pigments de fer sont dégraissés avant le dépôt du revêtement électriquement conducteur.

10. Procédé selon la revendication 9,
**caractérisé en ce**
**que** le dégraissage se fait en traitant les pigments de fer avec de l'hydroxyde de sodium dans un solvant organique, de préférence de l'éthanol.

11. Procédé selon l'une quelconque des revendications 8 à 10,
**caractérisé en ce**
**que** le matériau électriquement conducteur est déposé par voie chimique humide en utilisant un dépôt autocatalytique avec ou sans agent réducteur.

12. Procédé selon l'une quelconque des revendications 8 à 11,
**caractérisé en ce**
**que** le matériau conducteur est déposé en phase gazeuse sur les pigments de fer dans un procédé à lit fluidisé.

13. Procédé selon l'une quelconque des revendications 8 à 12,
**caractérisé en ce**
**que** le matériau conducteur est déposé d'abord par dépôt autocatalytique en l'absence d'agent réducteur et ensuite par réduction avec un agent réducteur.

14. Procédé selon la revendication 11 ou la revendication 13,
**caractérisé en ce**
**que** l'agent réducteur est choisi dans le groupe constitué par l'hydrazine, des aldéhydes, le méthanol, l'éthanol, des sucres, l'hypophosphite, le formaldéhyde ainsi que des mélanges de ceux-ci.

15. Procédé selon l'une quelconque des revendications 8 à 14,
**caractérisé en ce**
**que** le métal ou l'alliage métallique est choisi dans le groupe constitué par le rhodium, le nickel, l'argent, leurs mélanges ainsi que des alliages de ces métaux.

16. Procédé selon l'une quelconque des revendications 8 à 14,
**caractérisé en ce**
**que** les polymères électriquement conducteurs sont choisis dans le groupe constitué par le polypyrrole, le polythiophène, le polyphénylène, la polyaniline, le polyacétylène ainsi que des mélanges de ceux-ci.

17. Procédé selon l'une quelconque des revendications 8 à 16,
**caractérisé en ce**
**que** les pigments électriquement conducteurs sont de type lamellaire.

18. Mélange de pigments,
**caractérisé en ce**
**que** le mélange de pigments comprend un mélange de pigments électriquement conducteurs lamellaires selon l'une quelconque des revendications 1 à 7.

19. Utilisation de pigments électriquement conducteurs selon l'une quelconque des revendications 1 à 7 ou d'un mélange de pigments selon la revendication 18 dans des revêtements électriquement conducteurs et/ou dans des objets électriquement conducteurs.

20. Utilisation de pigments électriquement conducteurs selon l'une quelconque des revendications 1 à 7 ou d'un mélange de pigments selon la revendication 18 dans des revêtements ou des objets assurant un blindage contre le rayonnement électromagnétique.

21. Utilisation de pigments électriquement conducteurs selon l'une quelconque des revendications 1 à 7 ou d'un mélange de pigments selon la revendication 18 dans des commutateurs ou des revêtements intelligents, dans lesquels l'application d'un champ magnétique et/ou d'un champ électrique a pour effet d'orienter les pigments électriquement conducteurs dans une direction voulue.

22. Objet,
**caractérisé en ce**
**que** l'objet contient et/ou présente des pigments électriquement conducteurs selon l'une quelconque des revendications 1 à 7 ou un mélange de pigments selon la revendication 18.

23. Objet selon la revendication 22,
**caractérisé en ce**
**que** l'objet est un élément de sécurité, un document de sécurité, un objet de sécurité ou un matériau transparent.
